(19) **Europäisches Patentamt**

**European Patent Office**

**Office européen des brevets**

(11) Veröffentlichungsnummer : **0 554 494 B1**

(12) **EUROPÄISCHE PATENTSCHRIFT**

(45) Veröffentlichungstag der Patentschrift :
14.06.95 Patentblatt 95/24

(51) Int. Cl.$^6$ : **H03H 21/00**

(21) Anmeldenummer : **92102094.7**

(22) Anmeldetag : **07.02.92**

(54) **Adaptives nichtrekursives Digitalfilter.**

(43) Veröffentlichungstag der Anmeldung :
**11.08.93 Patentblatt 93/32**

(45) Bekanntmachung des Hinweises auf die
Patenterteilung :
**14.06.95 Patentblatt 95/24**

(84) Benannte Vertragsstaaten :
**DE FR GB IT NL SE**

(56) Entgegenhaltungen :
**EP-A- 0 121 992**
**EP-A- 0 453 201**

(56) Entgegenhaltungen :
**IEEE TRANSACTIONS ON CIRCUITS AND SY-
STEMS Bd. 34, Nr. 10, Oktober 1987, NEWY-
ORK US Seiten 1152 - 1160 MIKHAEL ET AL
'fast algorithms for block FIRadaptive digital
filtering'**
**PATENT ABSTRACTS OF JAPAN vol. 15, no.
506 (E-1148)20. Dezember 1991**

(73) Patentinhaber : **SIEMENS
AKTIENGESELLSCHAFT
Wittelsbacherplatz 2
D-80333 München (DE)**

(72) Erfinder : **Lucioni, Gonzalo, Dr.-Ing.
Wasserstrasse 420a
W-4630 Bochum (DE)**
Erfinder : **Gazsi, Lajos, Dr.-Ing.
Faunastrasse 23
W-4000 Düsseldorf (DE)**

## Beschreibung

Die Erfindung betrifft ein adaptives nichtrekursives Digitalfilter nach dem Oberbegriff des Patentanspruchs 1 bzw. nach dem Oberbegriff des Patentanspruchs 7.

Adaptive Digitalfilter sind in vielen Bereichen der zeitdiskreten Signalverarbeitung, insbesondere in den Bereichen Systemanalyse, Echokompensation bei Zweidraht-Vierdrahtübergängen, Leitungsentzerrung und Sprachverarbeitung von großer Bedeutung. Das Charakteristikum solcher adaptiver Digitalfilter im Vergleich zu konstanten Digitalfiltern ist, daß die Filterparameter, welche die Übertragungseigenschaften bestimmen, gegenüber einem Gütefunktional optimal eingestellt werden. Ein derartiges Gütefunktional ist beispielsweise dadurch gegeben, daß der mittlere quadratische Fehler des Ausgangssignals des adaptiven Digitalfilters gegenüber einem Referenzsignal minimiert wird.

Dieses allgemein als Least-Mean-Square-Algorithmus oder kurz als LMS-Algorithmus bekannte Verfahren ist beispielsweise bei B. Widrow, S.D. Stearns, Adaptive Signal Processing, Prentice Hall, Englewood Cliffs, N.J. 1985, insbesondere Seiten 99 bis 114, beschrieben. Auf Seite 290 der gleichen Veröffentlichung ist zudem in einem Blockdiagramm die Realisierung eines nach dem LMS-Algorithmus verfahrenden adaptiven nichtrekursiven Digitalfilters gezeigt, bestehend aus einer Filtereinheit mit steuerbaren Filterkoeffizienten und einer Steuereinheit, die die Filterkoeffizienten abhängig von einem an die Filtereinheit angelegten Eingangssignal sowie von der Differenz zwischen einem Referenzsignal und einem von der Filtereinheit abgegebenen Ausgangssignal entsprechend den jeweils kleinsten mittleren Fehlerquadraten steuert.

Der LMS-Algorithmus zeichnet sich zwar gegenüber anderen Verfahren, wie etwa dem Newton-Verfahren, durch einen geringeren Aufwand bei der Realisierung aus, weist jedoch nicht immer zufriedenstellende Konvergenzeigenschaften auf. Darüber hinaus geht der LMS-Algorithmus von der Annahme stationärer, stochastischer Signale aus. Das Anwendungsgebiet für nach dem LMS-Algorithmus arbeitende adaptive nichtrekursive Digitalfilter wird dadurch stark eingeschränkt.

Aufgabe der Erfindung ist es daher, ein adaptives nichtrekursives Digitalfilter anzugeben, das diesen Nachteil nicht aufweist.

Die vorstehend aufgezeigte Aufgabe wird bei einem gattungsgemäßen adaptiven nichtrekursiven Digitalfilter durch die kennzeichnenden Merkmale des Patentanspruchs 1 gelöst.

Die Erfindung wird nachfolgend anhand der in den Figuren der Zeichnung dargestellten Ausführungsbeispiele näher erläutert, wobei gleiche Elemente mit gleichen Bezugszeichen versehen sind. Es zeigt:

Figur 1       eine erste, allgemeine Ausführungsform eines erfindungsgemäßen adaptiven nichtrekursiven Digitalfilters in einem Blockdiagramm und

Figur 2       eine zweite, konkrete Ausführungsform eines erfindungsgemäßen adaptiven nichtkursiven Digitalfilters in einem Blockdiagramm.

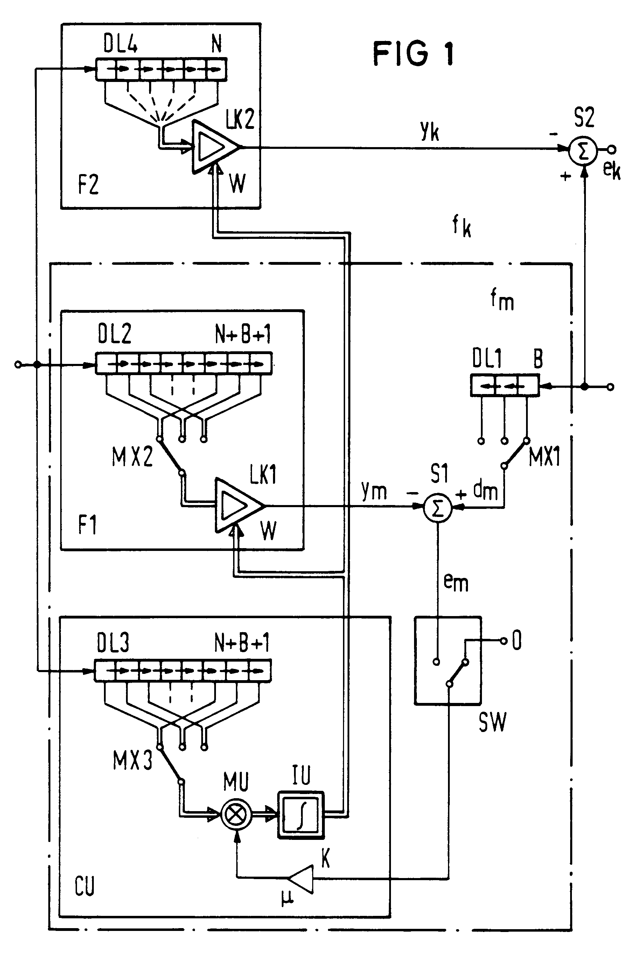

Ein erfindungsgemäßes adaptives nichtrekursives Digitalfilter weist gemäß Figur 1 eine Filtereinheit F1 mit N steuerbaren Filterkoeffizienten W und eine Steuereinheit CU, die die Filterkoeffizienten W abhängig von einem an die Filtereinheit F1 angelegten Eingangssignal $x_k$ mit gegebener Abtastrate $f_k$ sowie von der durch einen Subtrahierer S1 gebildeten Differenz zwischen einem Referenzsignal $d_k$ und einem von der Filtereinheit F1 abgegebenen Ausgangssignal $y_m$ entsprechend den jeweils kleinsten mittleren Fehlerquadraten steuert, auf. Dabei werden Filtereinheit F1 und Steuereinheit CU bei einer gegenüber der Abtastrate $f_k$ des Eingangssignals $x_k$ entsprechend erhöhten Abtastrate $f_m$ betrieben. Eingangssignal $x_k$ und Referenzsignal $d_k$ werden zwischen zwei Abtastzeitpunkten des Eingangssignals $x_k$ fortlaufend, also mehrmals, mit zyklisch sich verändernder Verzögerung abgetastet.

Zudem ist eine bei der gegebenen Abtastrate $f_k$ betriebene, weitere Filtereinheit F2 vorgesehen, die ebenfalls die durch die Steuereinheit CU gesteuerten Filterkoeffizienten W aufweist. Die weitere Filtereinheit F2 wird durch das Eingangssignal $x_k$ angesteuert und gibt ein weiteres Ausgangssignal $y_k$ ab. Außerdem ist eine durch das Referenzsignal $d_k$ angesteuerte Verzögerungseinheit DL1 mit B Ausgängen, an denen das Referenzsignal $d_k$ unterschiedlich verzögert anliegt, und eine nachfolgende Multiplexeinheit MX1, die mit der erhöhten Abtastrate $f_m$ zyklisch nacheinander einen der Ausgänge der Verzögerungseinheit DL1 durchschaltet, vorgesehen.

Die Filtereinheit F1 umfaßt eine durch das Eingangssignal $x_k$ angesteuerte Verzögerungseinheit DL2 mit N+B-1 Ausgängen, die B sich einander teilweise überlappenden Gruppen zu jeweils N aufeinanderfolgenden Ausgängen zugeordnet sind, eine nachfolgende Multiplexeinheit MX2, die mit der erhöhten Abtastrate $f_k$ jeweils eine Gruppe von Ausgängen der Verzögerungseinheit DL2 zyklisch nacheinander und synchron zur Multiplexeinheit MX1 durchschaltet, sowie daran anschließend eine Kombiniereinheit LK1, die die jeweils durchgeschalteten Ausgänge der Verzögerungseinheit DL2 mit den jeweiligen gesteuerten Filterkoeffizienten W bewertet und additiv miteinander verknüpft. Der Ausgang der Kombiniereinheit LK1 ist auf einen Eingang des Subtrahierers S1 geführt, dessen anderer Eingang an den Ausgang der Multiplexeinheit MX1 angeschlossen ist. Die

2

EP 0 554 494 B1

Steuereinheit CU enthält eine durch das Eingangssignal $x_k$ angesteuerte-Verzögerungseinheit DL3 mit N+B-1 Ausgängen, die B sich einander teilweise überlappenden Gruppen zu jeweils N aufeinanderfolgenden Ausgängen zugeordnet sind, eine nachfolgende Multiplexeinheit MX3, die mit der erhöhten Abtastrate $f_m$ jeweils eine Gruppe von Ausgängen der Verzögerungseinheit DL3 zyklisch nacheinander und synchron zur Multiplexeinheit MX1 durchschaltet und daran anschließend eine Multipliziereinheit MU, die zudem unter Zwischenschaltung eines Koeffizientenglieds K mit dem Ausgang des Subtrahierers S1 verbunden ist. Schließlich ist der Multipliziereinheit MU eine Integriereinheit IU nachgeschaltet.

Die weitere Filtereinheit F2 umfaßt eine durch das Eingangssignal $x_k$ angesteuerte Verzögerungseinheit DL4 mit N Ausgängen und eine nachfolgende Kombiniereinheit LK2, die die Ausgänge der Verzögerungseinheit DL4 mit den jeweiligen, gesteuerten Filterkoeffizienten W bewertet und additiv miteinander verknüpft. Die Filterkoeffizienten W bei den beiden Kombiniereinheiten LK1, LK2 werden durch Signale gesteuert, die an den Ausgängen der Integriereinheit IU anliegen.

In Weiterbildung der Erfindung ist eine Überwachungseinrichtung SW vorgesehen, die zwischen den Subtrahierer S1 und das Koeffizientenglied K geschaltet ist und die bei Absinken eines am Ausgang des Subtrahierers S1 auftretenden Fehlersignals $e_m$ unter einen gegebenen Mindestbetragswert das Fehlersignal $e_m$ gleich Null setzt.

Außerdem ist der Ausgang der Kombiniereinheit LK2, der das weitere Ausgangssignal $y_k$ führt, mit einem Eingang eines Subtrahierers S2 verbunden, an dessen anderen Eingang das Referenzsignal $d_k$ angelegt ist. Am Ausgang des Subtrahierers S2 tritt ein Empfangssignal $e_k$ auf. In diesem Fall sei das Eingangssignal $x_k$ ein Sendesignal und das Referenzsignal $d_k$ ein mit einem Echo behaftetes Empfangssignal, wie beispielsweise bei einer Fernsprecheinrichtung. Das Empfangssignal $e_k$ ist dabei echofrei.

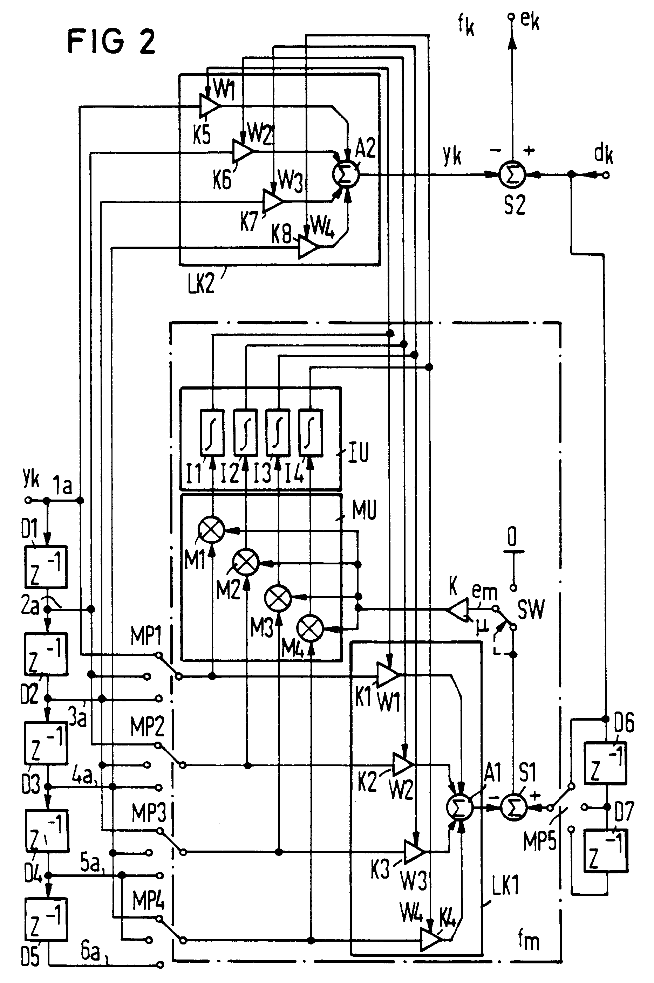

Bei der Ausführungsform nach Figur 2 wurde N = 4 und B = 3 gewählt. Darüber hinaus wurden die Verzögerungseinheiten DL2, DL3, DL4 aus Figur 1 durch eine einzige Verzögerungseinheit ersetzt. Diese besteht aus fünf in Reihe geschalteten Verzögerungselementen D1 bis D5 und weist sechs Ausgänge auf, entsprechend N+B-1 = 6 für N = 4 und B = 3, wobei der Eingang des ersten Verzögerungselements D1 gleichzeitig auch als Ausgang Verwendung findet. Am Eingang des ersten Verzögerungselements D1 ist das Eingangssignal $x_k$ angelegt. Die Ausgänge 1a bis 6a sind in B = 3 Gruppen zu je N = 4 Ausgängen eingeteilt. Gruppe 1 umfaßt dabei die Ausgänge 1a, 2a, 3a, 4a, Gruppe 2 die Ausgänge 2a, 3a, 4a, 5a und Gruppe 3 die Ausgänge 3a, 4a, 5a, 6a. Multiplexer MP1 bis MP4, mit jeweils B = 3 Eingängen und jeweils einem Ausgang schalten zyklisch mit der entsprechend erhöhten Abtastrate $f_m$ die jeweils zu einer Gruppe gehörenden Ausgänge durch. Das bedeutet, daß in einem ersten Schaltzustand der Multiplexer MP1 bis MP4 die Ausgänge 1a, 2a, 3a, 4a, in einem zweiten Schaltzustand die Ausgänge 2a, 3a, 4a, 5a, und schließlich in einem dritten Schaltzustand die Ausgänge 3a, 4a, 5a, 6a durchgeschaltet werden. Den Multiplexern MP1 bis MP4 sind jeweils zum einen Multiplizierer M1 bis M4 und zum anderen steuerbare Koeffizientenglieder K1 bis K4, mit Filterkoeffizienten $W_1$ bis $W_4$, deren Ausgänge auf einen Addierer A1 geführt sind, nachgeschaltet. An die Ausgänge der Multiplizierer M1 bis M4, an die zudem unter Zwischenschaltung des Koeffizientenglieds K mit dem Koeffizienten $\mu$ das Fehlersignal $e_m$ angelegt ist, sind jeweils Integrierer I1 bis I4 angeschlossen.

Der Ausgang des Addierers A1 ist auf einen Eingang des Subtrahierers S1 geführt, dessen anderer Eingang mit dem Ausgang eines Multiplexers MP5 verbunden ist. Dieser weist drei Eingänge auf, die an die Ausgänge zweier in Reihe geschalteter Verzögerungselemente D6 und D7 sowie an den Eingang des Verzögerungselements D6 angeschlossen sind. Am Eingang des Verzögerungselements D6 ist das Referenzsignal $d_k$ angelegt. Die vier Multiplexer MP1 bis MP4, der Multiplexer MP5 die vier Integrierer I1 bis I4, die Multiplizierer M1 bis M4 sowie die Verzögerungselemente D6 und D7 bilden die Multiplexeinheiten MX2 und MX3 bzw. die Multiplexeinheit MX1 bzw. die Integriereinheit IU bzw. die Multipliziereinheit MU bzw. die Verzögerungseinheit DL1 nach Figur 1. Die Koeffizientenglieder K1 bis K4 in Verbindung mit dem Addierer A1 bilden eine Kombiniereinheit entsprechend der Kombiniereinheit LK1 nach Figur 1. Entsprechend Figur 1 ist auch in Figur 2 der Ausgang des Subtrahierers S1 auf das Schaltwerk SW geführt, das abhängig von einem Mindestbetragswert entweder das Ausgangssignal des Subtrahierers S1 oder ein Nullsignal als Fehlersignal $e_m$ über das Koeffizientenglied an die Multiplizierer M1 bis M4 abgibt. Die Integrierer I1 bis I4, die Multiplexer MP1 bis MP5, die Multiplizierer M1 bis M4, die steuerbaren Koeffizientenglieder K1 bis K4, die Schalteinheit SW, das Koeffizientenglied K, der Addierer A1 sowie der Subtrahierer S2 in Verbindung mit den Verzögerungselementen D1 bis D7 werden mit der entsprechend erhöhten Abtastrate $f_m$ betrieben. Die Abtastrate $f_m$ hängt von der Abtastrate $f_k$ des Eingangssignals $x_k$ sowie von der Anzahl B der Ausgänge der Verzögerungseinheit DL1 mit den Verzögerungselementen D6 und D7 sowie einem gegebenen Faktor M wie folgt ab:

$$f_m = MBf_k \qquad \text{mit } M>1 \qquad (1)$$

Durch die Integrierer I1 bis I4 werden neben den Koeffizientengliedern K1 bis K4 auch Koeffizientenglieder K5 bis K8 mit jeweils den Filterkoeffizienten $W_1$ bis $W_4$ gesteuert, deren Ausgänge auf einen Addierer A2 geführt sind, an dessen Ausgang das weitere Ausgangssignal $y_k$ anliegt. Eingangsseitig sind die Koeffizienten-

3

glieder K5 bis K8 mit den der ersten Gruppe zugehörigen Ausgängen 1a, 2a, 3a, 4a der Verzögerungselemente D1 bis D5 verbunden.

Der Ausgang des Addierers A2 ist mit dem Eingang des Subtrahierers S2 verschaltet, dessen Ausgang das Empfangssignal $e_k$ führt. Die Koeffizientenglieder K5 bis K8 in Verbindung mit dem Addierer A2 nach Figur 2 entsprechen der Kombiniereinheit LK2 nach Figur 1.

Neben einer direkten schaltungstechnischen Realisierung ist alternativ auch eine Implementierung eines erfindungsgemäßen adaptiven nichtrekursiven Digitalfilters in eine Datenverarbeitungseinrichtung, insbesondere in ein Signalprozessorsystem, möglich. Die in den Figuren 1 und 2 dargestellten Blockdiagramme können dazu ohne weiteres in entsprechende Programme umgesetzt werden. Dabei werden beispielsweise einzelne Funktionsstrukturen als Unterprogramme ausgeführt. Entsprechend vorbereitete Signalverarbeitungseinrichtungen führen dann unter Programmsteuerung fortlaufend jeweils zu diskreten Abtastzeitpunkten des Eingangssignals $x_k$ beispielsweise die nachfolgend beschriebenen Verfahrensschritte durch. Zunächst werden Abtastwerte des Eingangssignals $x_k$ und des Referenzsignals $d_k$ für jeweils eine bestimmte Anzahl von Abtastzeitpunkten gespeichert. N+B-1 aufeinanderfolgende gespeicherte Abtastwerte des Eingangssignals $x_k$ werden B sicheinander teilweise überlappenden Gruppen zu je N Abtastwerten zugeordnet. Anschließend wird die Summe über alle einer bestimmten Gruppe angehörenden mit jeweils einem der Filterkoeffizienten W bewerteten Abtastwerte des Eingangssignals $x_k$, das weitere Ausgangssignal $y_k$ ergebend, gebildet. Schließlich werden dem Faktor M entsprechend mehrmals zum einen die gespeicherten Abtastwerte des Eingangssignals $x_k$ zyklisch und gruppenweise mit dem durch den Koeffizienten K bewerteten Fehlersignal $e_m$ multipliziert sowie anschließend jeweils für sich die Steuersignale für die Koeffizienten W ergebend, integriert und zum anderen zyklisch und gruppenweise die Summen über alle jeweils mit einem der Filterkoeffizienten W bewerteten, der jeweiligen Gruppe angehörenden Abtastwerte des Eingangssignals $x_k$ gebildet und diese von einem der B gespeicherten Abtastwerte des Referenzsignals $d_k$, das Fehlersignal $e_m$ ergebend, subtrahiert.

In Weiterbildung der Erfindung wird das weitere Ausgangssignal $y_k$ von dem Referenzsignal $d_k$, das Empfangssignal $e_k$ ergebend, subtrahiert.

Die Erfindung ebenfalls weiterbildend ist vorgesehen, daß bei Absinken des zweiten Fehlersignals $e_m$ unter einem gegebenen Minimalbetragswert, das Fehlersignal $e_m$ gleich Null gesetzt wird.

Nachdem zuvor der prinzipielle Aufbau erfindungsgemäßer adaptiver nichtrekursiver Digitalfilter beschrieben worden ist, wird nun nachfolgend deren Funktionsweise formal näher dargelegt.

Ausgehend von einem nichtrekursiven Digitalfilter der zweiten kanonischen Struktur mit N Koeffizienten $w_1,...,w_N$, die als Koeffizientenvektor $W = (w_1,...,w_N)^T$ beschrieben werden können, hängen das Eingangssignal $x_k$ und das weitere Ausgangssignal $y_k$ in folgender Weise zusammen:

$$y_k = X_k^T \cdot W = W^T \cdot X_k \text{ mit } X_k = (x_k, x_{k-1},...x_{k-N+1})^T \quad (2)$$

Der Eingangssignalvektor $X_k$ beschreibt die durch die Verzögerungseinheiten bzw. die Verzögerungselemente unterschiedlich verzögerten bzw. die gespeicherten Abtastwerte des Eingangssignals $x_k$. Weiterhin sei das Referenzsignal $d_k$, das mit dem Koeffizienten $\mu$ bewertet ist, gegeben. Gesucht wird ein Koeffizientenvektor $W_{opt}$, der das Fehlersignal $e_k = d_k - y_k$ über ein bestimmtes Zeitfenster von B Abtastwerten minimiert. Durch den LMS-Algorithmus ist für die Koeffizienten die folgende Adaptionsvorschrift bestimmt:

$$W = W + \mu \cdot e_k \cdot X_k \quad (3)$$

Bei minimalem Fehlersignal $e_k$, also $e_{k\,opt} = d_k - X_k^T W_{opt}$, so ergibt sich, daß durch die Rekursion in Gleichung (3) der Abstand von W zu $W_{opt}$ falls sich verringert,

$$|e_k| > 2(|e_{k,opt}|)/(2 - a_k) = |e_{min}| \quad (4)$$

ist, wobei $|e_{min}|$ den Mindestbetragswert darstellt und wobei zu erfüllen ist, daß

$$0 < a_k < 2 \quad \text{mit} \quad (5)$$
$$a_k = \mu \cdot |X_k|^2 \quad (6)$$

Die Bedingung in Gleichung (4) ist hinreichend für die Abnahme des Abstandes zwischen W und $W_{opt}$. Wählt man nun in Gleichung (3) statt des Koeffizienten $\mu$ eine zeitabhängige Variable $\mu_k$, so ändert sich Gleichung (5) zu

$$a_k = \mu_k \cdot |X_k|^2 \quad (7)$$

Die Bedingung in Gleichung (4) belegt unter anderem, daß eine Konvergenz des LMS-Algorithmus innerhalb eines Zeitfensters von B Abtastwerten, kurz Block genannt, dadurch verbessert werden kann, daß man statt einen Blockdurchlauf (wie beim LMS-Algorithmus) M > 1 Durchläufe macht. Diese Aussage gilt insbesondere dann, wenn Gleichung (4) "a priori" mit großer Reserve erfüllt ist. Darüber hinaus führt die Bedingung nach Gleichung (4), wenn man sie für ein erweitertes Zeitfenster betrachtet, durchaus zu einer gleichzeitigen Konvergenz des Koeffizientenvektors W gegen den optimalen Koeffizientenvektor $W_{opt}$ der entsprechenden Blöcke, falls Gleichung (4) für die einzelnen Blöcke erfüllt ist.

Der Vorteil eines erfindungsgemäßen adaptiven nichtrekursiven Digitalfilters ist, daß eine Beschränkung auf stationäre stochastische Signale nicht gegeben ist. Die Konvergenzeigenschaften sind in jedem Betriebsfall hinreichend. Darüber hinaus besteht der erforderliche Mehraufwand lediglich in einem zusätzlichen adaptiven Hintergrundfilter und in einem zusätzlichen Speicher, so daß der anderen Verfahren gegenüber vorteilhafte, geringe Aufwand des LMS-Algorithmus weitgehend erhalten bleibt. Dies ist insbesondere dadurch der Fall, da ein erfindungsgemäßes adaptives Digitalfilter funktional identische Strukturen aufweist, die sowohl für eine direkte schaltungstechnische Realisierung, als auch für eine Implementierung in eine programmgesteuerte Signalverarbeitungseinrichtung in gleicher Weise günstig sind.

**Patentansprüche**

1. Adaptives nichtrekursives Digitalfilter
   mit einer Filtereinheit (F1), mit N steuerbaren Filterkoeffizienten (W) und
   mit einer Steuereinheit (CU), die die Filterkoeffizienten (W) abhängig von einem an die Filtereinheit (F1) angelegten Eingangssignal ($x_k$)
   mit gegebener Abtastrate ($f_k$) sowie abhängig von der Differenz zwischen einem Referenzsignal ($d_k$) und einem von der Filtereinheit (F1) abgegebenen Ausgangssignal ($y_m$) entsprechend den jeweils kleinsten mittleren Fehlerquadraten steuert,
   **dadurch gekennzeichnet,**
   daß Filtereinheit (F1) und Steuereinheit (CU) bei erhöhter Abtastrate ($f_m$) das Eingangssignal ($x_k$) und das Referenzsignal ($d_k$) zwischen zwei Abtastzeitpunkten des Eingangssignals ($X_k$), fortlaufend mit zyklisch sich verändernder Verzögerung abtasten und
   daß eine bei der gegebenen Abtastrate ($f_k$) betriebene, weitere Filtereinheit (F2) mit N steuerbaren Filterkoeffizienten (W) vorgesehen ist, an die das Eingangssignal ($x_k$) angelegt ist, die ein weiteres Ausgangssignal ($y_k$) abgibt und deren Filterkoeffizienten (W) ebenfalls durch die Steuereinheit (CU) gesteuert werden.

2. Adaptives nichtrekursives Digitalfilter nach Anspruch 1,
   **dadurch gekennzeichnet,**
   daß eine durch das Referenzsignal ($d_k$) angesteuerte erste Verzögerungseinheit (DL1) mit B Ausgängen und eine nachfolgende erste Multiplexeinheit (MX1), die mit der erhöhten Abtastrate ($f_m$) zyklisch nacheinander einen der Ausgänge der ersten Verzögerungseinheit (DL1) durchschaltet, vorgesehen ist, daß die Filtereinheit (F1) eine durch das Eingangssignal ($x_k$) angesteuerte zweite Verzögerungseinheit (DL2) mit N+B-1 Ausgängen, die B sich einander teilweise überlappenden Gruppen zu jeweils N aufeinanderfolgenden Ausgängen zugeordnet sind, eine nachfolgende zweite Multiplexeinheit (MX2), die mit der erhöhten Abtastrate ($f_m$) jeweils eine Gruppe von Ausgängen der zweiten Verzögerungseinheit (DL2) zyklisch nacheinander und synchron zur ersten Multiplexeinheit (MX1) durchschaltet, sowie daran anschließend eine erste Kombiniereinheit (LK1), die die jeweils durchgeschalteten Ausgänge der zweiten Verzögerungseinheit (DL2) mit den jeweiligen gesteuerten Filterkoeffizienten (W) bewertet und additiv miteinander verknüpft, aufweist, daß der Ausgang der ersten Kombiniereinheit (LK1) auf einen Eingang eines ersten Subtrahierers (S1) geführt ist, dessen anderer Eingang an den Ausgang der ersten Multiplexeinheit (MX1) angeschlossen ist,
   daß die Steuereinheit (CU) eine durch das Eingangssignal ($x_k$) angesteuerte dritte Verzögerungseinheit (DL3) mit N+B-1 Ausgängen, die B sich einander teilweise überlappenden Gruppen zu jeweils N aufeinanderfolgenden Ausgängen zugeordnet sind, eine nachfolgende dritte Multiplexeinheit (MX3), die mit der erhöhten Abtastrate ($f_m$) jeweils eine Gruppe von Ausgängen der dritten Verzögerungseinheit (DL3) zyklisch nacheinander und synchron zur ersten Multiplexeinheit (MX1) durchschaltet, daran anschließend eine Multipliziereinheit (MU), die zudem unter Zwischenschaltung eines Koeffizientenglieds (K) mit dem Ausgang des ersten Subtrahierers (S1) verbunden ist, sowie eine der Multipliziereinheit (MU) nachgeschaltete Integriereinheit (IU) aufweist,
   daß die weitere Filtereinheit (F2) eine durch das Eingangssignal ($x_k$) angesteuerte vierte Verzögerungseinheit (DL4) mit N Ausgängen und eine nachfolgende zweite Kombiniereinheit (LK2), die die Ausgänge der vierten Verzögerungseinheit (DL4) mit den jeweiligen gesteuerten Filterkoeffizienten (W) bewertet und additiv miteinander verknüpft, aufweist, und daß die Ausgänge der Integriereinheit (IU) Signale führen, die zur Steuerung der Filterkoeffizienten (W) bei den beiden Filtereinheiten (F1, F2) vorgesehen sind.

3. Adaptives nichtrekursives Digitalfilter nach Anspruch 1 oder 2,

**dadurch gekennzeichnet,**
daß zweite und dritte Verzögerungseinheit (DL2, DL3) sowie zweite und dritte Multiplexeinheit (MX2, MX3) durch eine gemeinsame Verzögerungseinheit (DL) bzw. eine gemeinsame Multiplexeinheit (MX) gegeben sind.

4. Adaptives nichtrekursives Digitalfilter nach Anspruch 3,
**dadurch gekennzeichnet,**
daß an die Stelle der vierten Verzögerungseinheit (DL4) ein Teil der gemeinsamen Verzögerungseinheit tritt, dessen Ausgänge einer bestimmten Gruppe zugeordnet sind.

5. Adaptives nichtrekursives Digitalfilter nach einem der Ansprüche 1 bis 4,
**gekennzeichnet durch**
eine Überwachungseinrichtung (SW), die bei Absinken eines am Ausgang des ersten Subtrahierers (S1) auftretenden Fehlersignals ($e_m$) unter einem gegebenen Mindestbetragswert das Fehlersignal ($e_m$) gleich Null setzt.

6. Adaptives nichtrekursives Digitalfilter nach einem der Ansprüche 1 bis 5,
**gekennzeichnet durch**
einen zweiten Subtrahierer (S2) dem das Referenzsignal ($d_k$) und das weitere Ausgangssignal ($y_k$) zugeführt werden.

7. Adaptives nichtrekursives Digitalfilter nach Anspruch 1,
**dadurch gekennzeichnet,**
daß eine Signalverarbeitungseinrichtung vorgesehen ist, die unter Programmsteuerung fortlaufend jeweils zu diskreten Abtastzeitpunkten Abtastwerte des Eingangssignals ($x_k$) und des Referenzsignals ($d_k$) für jeweils eine bestimmte Anzahl von Abtastzeitpunkten speichert,
die N+B-1 aufeinanderfolgende gespeicherte Abtastwerte des Eingangssignals ($x_k$) B sich einander teilweise überlappenden Gruppen zu je N Abtastwerten zuordnet,
die Summe über alle einer bestimmten Gruppe angehörenden mit die jeweils einem der Filterkoeffizienten (W) bewerteten Abtastwerte des Eingangssignals ($x_k$), das weitere Ausgangssignal ($y_k$) ergebend, bildet, und
die mehrmals (M) zum einen die gespeicherten Abtastwerte des Eingangssignals ($x_k$) zyklisch und gruppenweise mit einem durch einen Koeffizienten (u) bewerteten Fehlersignal ($e_m$) multipliziert sowie anschließend jeweils für sich, die Steuersignale für die Koeffizienten (W) ergebend, integriert und zum anderen zyklisch gruppenweise die Summen über alle jeweils mit einem der Filterkoeffizienten (W) bewerteten, der jeweiligen Gruppe angehörenden Abtastwerte des Eingangssignals ($x_k$) bildet und diese von einem von B gespeicherten Abtastwerten des Referenzsignals ($d_k$), das Fehlersignal ($e_m$) ergebend, subtrahiert.

8. Adaptives nichtrekursives Digitalfilter nach Anspruch 7,
**dadurch gekennzeichnet,**
daß das Fehlersignal ($e_m$) bei Absinken unter einen gegebenen Mindestbetragswert gleich Null gesetzt wird.

9. Adaptives nichtrekursives Digitalfilter nach Anspruch 7 oder 8,
**dadurch gekennzeichnet,** daß das weitere Ausgangssignal ($y_k$) von dem Referenzsignal ($d_k$) subtrahiert wird.

## Claims

1. Adaptive non-recursive digital filter comprising a filter unit (F1) having N controllable filter coefficients (W), and comprising a control unit (CU) which controls the filter coefficients (W) as a function of an input signal ($x_k$), applied to the filter unit (F1), at a given sampling rate ($f_k$) and as a function of the difference between a reference signal ($d_k$) and an output signal ($y_m$), output by the filter unit (F1), in accordance with the least mean error squares in each case, characterized in that the filter unit (F1) and control unit (CU) sample the input signal ($x_k$) and the reference signal ($d_k$) continuously, between two sampling instants of the input signal ($x_k$) with a cyclically varying delay and at an increased sampling rate ($f_m$), and in that a further filter unit (F2), operated at the given sampling rate ($f_k$), is provided with N controllable filter coefficients (W), to which the input signal ($x_k$) is applied and which outputs a further output signal ($y_k$) and whose filter coefficients (W) are likewise controlled by the control unit (CU).

2. Adaptive non-recursive digital filter according to Claim 1, characterized in that provision is made of a first delay unit (DL1), which is triggered by the reference signal ($d_k$) and has B outputs, and of a downstream first multiplexing unit (MX1) which cyclically in succession switches through one of the outputs of the first delay unit (DL1) at the increased sampling rate ($f_m$), in that the filter unit (F1) has a second delay unit (DL2), which is triggered by the input signal ($x_k$) and has N+B-1 outputs which are assigned to B groups which partially overlap one another and each have N successive outputs, a downstream second multiplexing unit (MX2), which successively switches through one group of outputs of the second delay unit (DL2) cyclically in succession and synchronously with the first multiplexing unit (MX1) and at the increased sampling rate ($f_m$), as well as, connected thereto, a first combining unit (LK1) which weights the respectively switched-through outputs of the second delay unit (DL2) with the respective controlled filter coefficients (W) and combines them additively with one another, in that the output of the first combining unit (LK1) is led to one input of a first subtractor (S1) whose other input is connected to the output of the first multiplexing unit (MX1), in that the control unit (CU) has a third delay unit (DL3), which is triggered by the input signal ($x_k$) and has N+B-1 outputs which are assigned to B groups which partially overlap one another and each have N successive outputs, a downstream third multiplexing unit (MX3) which respectively switches through one group of outputs of the third delay unit (DL3) cyclically in succession and synchronously with the first multiplexing unit (MX1) and at the increased sampling rate ($f_m$), connected thereto a multiplying unit (MU) which, in addition, is connected with the interposition of a coefficient element (K) to the output of the first subtractor (S1), as well as an integrating unit (IU) downstream of the multiplying unit (MU), in that the further filter unit (F2) has a fourth delay unit (DL4), which is triggered by the input signal ($x_k$) and has N outputs, and a downstream second combining unit (LK2) which weights the outputs of the fourth delay unit (DL4) with the respective controlled filter coefficients (W) and combines them additively with one another, and in that the outputs of the integrating unit (IU) carry signals which are provided for controlling the filter coefficients (W) in the two filter units (F1, F2).

3. Adaptive non-recursive digital filter according to Claim 1 or 2, characterized in that second and third delay units (DL2, DL3) as well as second and third multiplexing units (MX2, MX3) are respectively provided as a common delay unit (DL) and a common multiplexing unit (MX).

4. Adaptive non-recursive digital filter according to Claim 3, characterized in that the place of the fourth delay unit (DL4) is taken by a portion of the common delay unit whose outputs are assigned to a specific group.

5. Adaptive non-recursive digital filter according to one of Claims 1 to 4, characterized by a monitoring device (SW) which sets an error signal ($e_m$) occurring at the output of the first subtractor (S1) equal to zero in the event that the error signal ($e_m$) drops below a given minimum value.

6. Adaptive non-recursive digital filter according to one of Claims 1 to 5, characterized by a second subtractor (S2), to which the reference signal ($d_k$) and the further output signal ($y_k$) are fed.

7. Adaptive non-recursive digital filter according to Claim 1, characterized in that a signal processing device is provided which under programmed control continuously respectively stores at discrete sampling instants sampled values of the input signal ($x_k$) and the reference signal ($d_k$) for a specific number of sampling instants in each case, which assigns N+B-1 successively stored sampled values of the input signal ($x_k$) to B groups, which partially overlap one another and have N sampled values each, which forms the sum over all sampled values, belonging to a specific group and weighted by in each case one of the filter coefficients (W), of the input signal ($x_k$), producing the further output signal ($y_k$), and, on one hand, multiply (M) multiplies the stored sampled values of the input signal ($x_k$) cyclically and in groups by an error signal ($e_m$) weighted by a coefficient ($\mu$) and subsequently integrates said sampled values separately in each case, producing the control signals for the coefficients (W), and on the other hand cyclically forms in groups the sums over all sampled values of the input signal ($x_k$) which are respectively weighted by one of the filter coefficients (W) and belong to the respective group, and subtracts said sums from one of the B stored sampled values of the reference signal ($d_k$), producing the error signal ($e_m$).

8. Adaptive non-recursive digital filter according to Claim 7, characterized in that the error signal ($e_m$) is set equal to zero upon dropping below a given minimum value.

9. Adaptive non-recursive digital filter according to Claim 7 or 8, characterized in that the further output signal $(y_k)$ is subtracted from the reference signal $(d_k)$.

**Revendications**

1. Filtre numérique adaptatif non récursif, comportant
une unité de filtre (F1) possédant N coefficients de filtre (W) commandables et
une unité de commande (CU), qui commande les coefficients de filtre (W) en fonction d'un signal d'entrée $(x_k)$ appliqué à l'unité de filtre (F1), avec une cadence d'échantillonnage donnée $(f_k)$, ainsi qu'en fonction de la différence entre un signal de référence $(d_k)$ et un signal de sortie $(y_m)$ fourni par l'unité de filtre (F1), en fonction des plus faibles carrés d'erreur moyens,
caractérisé par le fait
que l'unité de filtre (F1) et l'unité de commance (CU) échantillonnent en permanence, avec un retard variable de façon cyclique, le signal d'entrée $(x_k)$ et le signal de référence $(d_k)$ entre deux instants d'échantillonnage du signal d'entrée $(x_k)$, dans le cas d'une cadence d'échantillonnage $(f_m)$ accrue, et
qu'il est prévu une autre unité de filtre (F2), qui fonctionne à la cadence d'échantillonnage donnée $(f_k)$, qui comporte N coefficients de filtre commandables (W) , à laquelle est appliqué le signal d'entrée $(x_k)$, qui fournit un autre signal de sortie $(y_k)$ et dont les coefficients de filtre (W) sont également commandés par l'unité de commande (CU).

2. Filtre numérique adaptatif non récursif suivant la revendication 1, caractérisé par le fait
qu'il est prévu une première unité de retardement (DL1), qui est commandée par le signal de référence $(d_k)$ et comporte B sorties, et une première unité de multiplexage (MX1), qui est disposée en aval et qui connecte successivement de façon cyclique, à la cadence d'échantillonnage accrue $(f_m)$, l'une des sorties de la première unité de retardement (DL1),
que l'unité de filtre (F1) comporte une seconde unité de retardement (DL2), commandée par le signal d'entrée $(x_k)$ et comportant N+B-1 sorties, qui sont associés à B groupes en chevauchement partiel comprenant chacun N sorties successives, une seconde unité de multiplexage (MX2) en aval, qui connecte successivement de façon cylique et en synchronisme avec la première unité de multiplexage (MX1), à la fréquence d'échantillonnage accrue $(f_m)$, un groupe de sorties de la seconde unité de retardement (DL2), et, en aval de la seconde unité de multiplexage, une première unité combinatoire (LK1), qui pondère les sorties connectées, de la seconde unité de retardement (DL2) par les coefficients de filtre commandés (W) et les combine entre elles de façon additive,
que la sortie de la première unité combinatoire (LKI) est raccordée à une entrée d'un premier soustracteur (S1), dont l'autre entrée est raccordée à la sortie de la première unité de multiplexage (MX1),
que l'unité de commande (CU) comporte une troisième unité de retardement (DL3), qui est commandée par le signal d'entrée $(x_k)$ et comporte N+B-1 sorties, qui sont associées à B groupes en chevauchement partiel comprenant chacun N sorties successives, une troisième unité de multiplexage (MX3) en aval, qui connecte successivement de façon cyclique et en synchronisme avec la première unité de multiplexage (MX1), à la fréquence d'échantillonnage accrue $(f_m)$, un groupe de sorties de la troisième unité de retardement (DL3) , et, en aval de la troisième unité de multiplexage, une unité de multiplication (MU), qui est en outre reliée, moyennant le montage intercalé d'un circuit (K) de coefficients, à la sortie du premier soustracteur (S1), ainsi qu'une unité d'intégration (IU) branchée en aval de l'unité de multiplication (MU),
que l'autre unité de filtre (F2) comporte une quatrième unité de retardement (DL4), qui est commandée par le signal d'entrée $(x_k)$ et comporte N sorties, et une seconde unité combinatoire (LK2) en aval, qui pondère les sorties de la quatrième unité de retardement (DL4) avec les coefficients de filtre commandés (W) et les combine entre elles de façon additive, et
que les sorties de l'unité d'intégration (IU) véhiculent des signaux, qui sont prévus pour la commande des coefficients de filtre (W) dans les deux unités de filtre (F1,F2).

3. Filtre numérique adaptatif non récursif suivant la revendication 1 ou 2, caractérisé par le fait que les seconde et troisième unités de retardement (DL2, DL3) ainsi que les seconde et troisième unités de multiplexage (MX2, MX3) sont formées par une unité de retardement commune (DL) et par une unité de multiplexage commune (MX).

4. Filtre numérique adaptatif non récursif suivant la revendication 3, caractérisé par le fait qu'à la place de la quatrième unité de retardement (DL4) est disposée une partie de l'unité de retardement commune, dont

EP 0 554 494 B1

les sorties sont associées à un groupe déterminé.

5. Filtre numérique adaptatif non récursif suivant l'une des revendications 1 à 4, caractérisé par un dispositif de contrôle (SW), qui, lorsque le signal d'erreur ($e_m$), qui apparaît à la sortie du premier soustracteur (S1), est inférieur à une valeur absolue minimale donnée, met à zéro le signal d'erreur ($e_m$).

6. Filtre numérique adaptatif non récursif suivant l'une des revendications 1 à 5, caractérisé par un second soustracteur (S2), auquel sont envoyés le signal de référence ($d_k$) et l'autre signal de sortie ($y_k$).

7. Filtre numérique adaptatif non récursif selon la revendication 1, caractérisé par le fait qu'il est prévu un dispositif de traitement de signaux, qui, au moyen d'une commande programmée, mémorise en permanence, à des instants d'échantillonnage discrets, des valeurs d'échantillonnage du signal d'entrée ($x_k$) et du signal de référence ($d_k$) pour un nombre déterminé d'instants d'échantillonnage,
qui associe N+B-1 valeurs d'échantillonnage successives mémorisées du signal d'entrée ($x_k$) à B groupes, qui se chevauchent partiellement, comprenant chacun N valeurs d'échantillonnage,
qui forme la somme de toutes les valeurs d'échantillonnage, qui appartiennent à un groupe déterminé et sont pondérées par l'un des coefficients de filtre (W), du signal d'entrée ($x_k$), en fournissant un autre signal de sortie ($y_k$), et
qui, plusieurs fois (M), d'une part multiplie, de façon cyclique et par groupes, les valeurs d'échantillonnage mémorisées du signal d'entrée ($x_k$), par un signal d'erreur ($e_m$) pondéré par un coefficient (m), et ensuite les intègre chacune en produisant les signaux de commande pour les coefficients (W) et d'autre part forme cycliquement et par groupe les sommes de toutes les valeurs d'échantillonnage du signal d'entrée ($x_k$), qui sont pondérées par l'un des coefficients de filtre (W) et qui appartiennent au groupe respectif, et soustrait ces sommes de l'une de B valeurs d'échantillonnage mémorisées du signal de référence ($d_k$), en produisant le signal d'erreur ($e_m$).

8. Filtre numérique adaptatif non récursif suivant la revendication 7, caractérisé par le fait que le signal d'erreur ($e_m$) est mis à zéro lorsqu'il est inférieur à une valeur absolue minimale déterminée.

9. Filtre numérique adaptatif non récursif suivant la revendication 7 ou 8, caractérisé par le fait que l'autre signal de sortie ($y_k$) est soustrait du signal de référence ($d_k$).

9

FIG 1

FIG 2